# EUROPEAN PATENT SPECIFICATION

(11) **EP 4 258 356 B1**
(45) Date of publication and mention of the grant of the patent: **16.09.2026**
(21) Application number: 22167185.2
(22) Date of filing: 07.04.2022
(51) Int. Cl.: H10F 39/00

(54) **PIXEL MATRIX SENSOR AND METHOD OF MANUFACTURING THE SAME**
PIXELMATRIXSENSOR UND VERFAHREN ZUR HERSTELLUNG DESSELBEN
CAPTEUR A MATRICE DE PIXELS ET SON PROCÉDÉ DE FABRICATION

(43) Date of publication of application: 11.10.2023
(73) Proprietor: Airbus Defence and Space GmbH, 82024 Taufkirchen (DE)
(72) Inventor: Neuzner, Andreas, 82024 Taufkirchen (DE); Stute, Andreas, 82024 Taufkirchen (DE)
(74) Representative: Frenkel, Matthias Alexander

(56) References cited:
- US-A1- 2005 024 519
- US-A1- 2006 113 622
- US-A1- 2009 102 959
- US-A1- 2013 341 747

## Description

### FIELD OF INVENTION

The present disclosure relates to a method of manufacturing a pixel matrix sensor, particularly, a backside-illuminated pixel matrix sensor.

### BACKGROUND ART

A pixel matrix sensor, such as a two-dimensional staring array image sensor, typically includes an array of optical sensors for sensing light, such as optical images. The spectral sensitivity of such a pixel matrix sensor is intrinsically defined by material properties. In order to modify the spectral sensitivity, additional optical filters are placed before the optical sensors of the pixel matrix sensor.

When placing an optical filter before optical sensors in a pixel matrix sensor, it is important to ensure the alignment of the optical filter relative to the surface of the optical sensors. Especially, the width of a gap between the optical filter and the optical sensors (namely, a size or height of a gap between the optical filter and the sensor or a distance between the optical filter and the sensor) and the spatial homogeneity of this width or distance across the surface of the optical sensors may affect the etaloning effects occurring in the gap between the optical filter and the optical sensors.

In one conventional method of mounting an optical filter before an image sensor, a dedicated filter holder is firstly prepared, for example, by milling a metal. An optical filter is then mounted to the dedicated filter holder. Thereafter, the dedicated filter holder and the mounted optical filter are placed before the optical sensors and attached to a surrounding structure of the optical sensors or a surrounding structure adjacent to the optical sensors in the pixel matrix sensor. This conventional method does not require a special attachment features on the image sensor. However, the width of a gap between the optical filter and the image sensor is subject to a tolerance chain that comprises many different elements and it is typically very hard to control the width of a gap between the optical filter and the image sensor.

In another conventional method as described in US 2021/0247232 A1, an optical filter is directly deposited onto and integrated to the sensor layer, in which optical sensors are formed, on an image sensor wafer and may be lithographically structured to provide desired optical properties prior to sawing the wafer. This technique is, however, limited to a small subset of materials for optical filters and to Silicon-based image sensors. Semiconductor materials like the ones required for infrared image sensors are either not suitable or too complex to be manufactured by this conventional method. The types and applications of image sensors are thus restricted by this method of mounting an optical filter before the image sensor. US 2005/024519 A1 shows another method of manufacturing a pixel matrix sensor according to the prior-art.

Thus, in the conventional art, there is a need for a method of mounting an optical filter before an optical sensor in a pixel matrix sensor that allows for an easy control of the width of a gap between the optical filter and the optical sensor in preparing pixel matrix sensors of different materials.

### SUMMARY OF INVENTION

An object of the present disclosure is thus to provide a method of manufacturing of a pixel matrix sensor for resolving the above problems of the conventional art.

The invention is defined by the appended claims. In an aspect, the present disclosure provides a method of preparing a pixel matrix sensor. The method includes: providing a substrate including a first side and a second side opposite to the first side; depositing a sensor layer onto the first side of the substrate, the sensor layer including an optical sensor in a photoactive region of the sensor layer; and preparing a substrate spacer on the second side of the substrate, the substrate having a central area above the photoactive region of the sensor layer and the substrate spacer being outside of the central area of the substrate. The step of preparing the substrate spacer includes: removing completely the substrate in the central area from the second side of the substrate to create a gap in the central area and expose a surface of the sensor layer to the gap; leaving the substrate spacer on the second side of the substrate; and attaching an optical filter to the substrate spacer.

By the method of preparing or manufacturing a pixel image sensor, a substrate spacer is prepared by removing the substrate in the central area and leaving the substrate spacer on the second side of the substrate. The optical filter is then attached to the substrate spacer. This provides an easy, cost-efficient, and robust way of mounting an optical filter before the optical sensor in the sensor layer. In particular, the removal of the substrate from the second side improves the optical properties by reducing the amount of light absorbed by the substrate.

In the method disclosed above, the substrate spacer can thus serve as a mechanical spacer between the optical filter and the sensor layer to maintain a very well defined mean width of the gap between the optical filter and the sensor layer, namely, very good parallelism between the two sides of the gap. The geometry, especially the height, of the substrate spacer can be very well defined, for example, by providing a substrate with a well-defined thickness before preparing the substrate spacer. The width of the gap between the optical filter and the sensor layer can therefore be easily controlled in preparing pixel matrix sensors of different materials, which helps control etaloning effects occurring in the gap.

In some further embodiments, the substrate spacer may include a plurality of spacer sections separate from each other. For example, the substrate spacer may have two spacer sections on two respective edges of the second side of the substrate or may have three spacer sections, such as in a form of three pillars.

In some other embodiments, the substrate spacer may include a rim surrounding the gap. Further, the rim may include an opening connecting the gap from an inner side of the rim to an outer side of the rim. For example, the rim may be broken in a least one position to form the opening. This prevents a complete sealing of the gap at the inner side of the rim and therefore prevents damages to the components of the pixel matrix sensor caused by a pressure difference between a sealed gap at the inner side of the rim and the surrounding at the outer side of the rim when the pixel matrix sensor is under certain applications, such as space applications or cryogenic on-ground applications.

In still further embodiments, the step of attaching the optical filter may include applying a liquid adhesive between the optical filter and the substrate spacer. The liquid adhesive may be applied to a side of the substrate spacer facing away from the gap. By virtue of the substrate spacer, the optical filter can be easily attached by a liquid adhesive and mounted before the sensor layer. The substrate spacer serves not only as a holder for the optical filter but also as a stopper preventing the liquid adhesive from creeping into the gap surrounded by the substrate spacer.

In some embodiments, in the step of providing the substrate, the first side of the substrate may be parallel to the second side of the substrate. By the parallelism of the two sides of the substrate, the substrate spacer prepared according to the present disclosure can have a surface in parallel to the sensor layer formed on the other side of the substrate. This helps maintain a very well defined mean width of a gap between the optical filter and the sensor layer, namely, very good parallelism between the optical filter and the sensor layer.

In some embodiments, the optical filter may have a flat surface facing the substrate spacer and the flat surface of the optical filter may be parallel to the surface of the sensor layer exposed to the gap. It is thereby able to ensure a very well defined mean width of a gap or parallelism between the optical filter and the sensor layer.

In another aspect, the present disclosure provides a pixel matrix sensor obtainable by a method of the present disclosure as presented above.

In still another aspect not forming part of the present invention, the present disclosure provides a pixel matrix sensor. The pixel matrix sensor includes a substrate. The substrate includes a first side and a second side opposite to the first side. The pixel matrix sensor further includes a sensor layer on the first side of the substrate, the sensor layer including an optical sensor in a photoactive region of the sensor layer. A substrate spacer of the substrate is on the second side of the substrate. The substrate has a central area above the photoactive region of the sensor layer and the substrate spacer is outside of the central area. The substrate further includes a gap in the central area and a surface of the sensor layer (120) is exposed to the gap. The pixel matrix sensor further includes an optical filter attached to the substrate spacer.

The pixel matrix sensor, as disclosed above, has a very robust structure of an optical filter mounted before the sensor layer. In particular, by the substrate spacer serving as a mechanical spacer and a holder for the optical filter, there is no need to include additional holder structures. This allows for an easier and more cost-efficient way of mounting an optical filter before the sensor layer. As a result, the alignment of the optical filter relative to the sensor layer can be ensured to maintain a very well defined mean width of a gap between the optical filter and the sensor layer, which helps control etaloning effects occurring in the gap. Further, the size and the costs of the pixel matrix sensor can be reduced.

In some embodiments, the substrate spacer may include a plurality of spacer sections separate from each other. For example, the substrate spacer may have two spacer sections on two respective edges of the second side of the substrate or may have three spacer sections, such as in a form of three pillars.

In some other embodiments, the substrate spacer may include a rim surrounding the gap. The rim may include an opening connecting the gap from an inner side of the rim to an outer side of the rim. For example, the rim may be broken in at least one position to provide an opening connecting the gap from an inner side of the rim to an outer side of the rim. This prevents a complete sealing of the gap at the inner side of the rim.

In still further embodiments, the optical filter may be attached to the substrate spacer by an adhesive. The adhesive may be on a side of the substrate spacer facing away from the gap. The substrate spacer thus serves not only as a holder for the optical filter but also as a stopper preventing the adhesive from entering into the gap above the photoactive region.

In some embodiments, the optical filter may have a flat surface facing the substrate spacer, and the flat surface of the optical filter may be parallel to the surface of the sensor layer exposed to the gap. This ensures a very well defined mean width of the gap between the optical filter and the sensor layer.

### Brief Description of Drawings

In the drawings, which are not necessarily drawn to scale, like numerals may reference similar components in different figures. The shapes of elements illustrated in the drawings are not intended to limit the embodiments or the scope of the present disclosure, unless explicitly specified. The drawings illustrate various embodiments of the present disclosure.
Fig. 1 is a diagram illustrating a cross-sectional view of a pixel matrix sensor according to an embodiment of the present disclosure.
Figs. 2 to is a flowchart illustrating a method of preparing a pixel matrix sensor according to the present disclosure.
Figs. 3A to 3E are diagrams illustrating cross-sectional views of a manufacturing flow for producing the pixel matrix sensor illustrated in Fig. 1.

### Detailed Description

In the present disclosure, when an element, such as a layer, a region, or a substrate, is referred to as being on, connected to, connected to, coupled to, or attached to another element, it may be directly on, connected, coupled, or attached to the other element, or one or more intervening elements may be present. In contrast, when an element is referred to as being directly on, directly connected to, directly coupled to, or directly attached to another element or layer, there are no intervening elements or layers present. Although the terms directly on, directly connected to, directly coupled to, or directly attached to may not be used throughout the detailed description, elements that are shown (e.g., in the drawings) as being directly on, directly connected, directly coupled, or directly attached can be referred to as such.

Spatially relative terms (e.g., on, before, top, bottom, and so forth) are intended to encompass different orientations of the device in use or operation in addition to the orientation depicted in the figures.

The present disclosure relates to a pixel matrix sensor and a method of preparing the same. A pixel matrix sensor may be a staring array image sensor, a time delay integration image sensor, or a time-of-flight image sensor. More specifically, the present disclosure provides a method of preparing a pixel matrix sensor, in which a substrate of the sensor layer is structured to provide a substrate spacer as a mechanical spacer for mounting an optical filter before the sensor layer, and a pixel matrix sensor having such a substrate spacer.

The method and the pixel matrix sensor according to the present disclosure provide technical advantages over the conventional art in that an optical filter can be mounted before the sensor layer in an easy, cost-efficient, and robust way and that the substrate spacer can serve as a mechanical spacer between the optical filter and the sensor layer to maintain a very well defined mean width of a gap between the optical filter and the sensor layer. The features and the technical advantages achieved will become clear in view of the following embodiments.

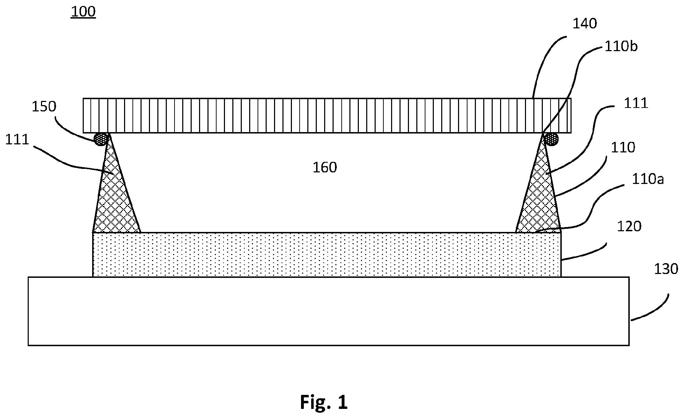

Fig. 1 illustrates a cross-sectional view of a pixel matrix sensor according to an embodiment of the present disclosure. As can be seen from the bottom to the top of Fig. 1, the pixel matrix sensor includes a sensor layer 120, a substrate 110, and an optical filter 140. A gap 160 is between the substrate 110 and the optical filter 140.

The pixel matrix sensor may be mounted on an integrated circuit layer 130, which may be a readout integrated circuit layer configured to read signals sensed by the sensor layer 120 for further processing of the signals.

The sensor layer 120 includes an optical sensor or an array of optical sensors in a photoactive region of the sensor layer for detecting light or images entering the sensor layer. Though not illustrated in Fig. 1, the sensor layer 120 may include an array of optical sensors in the photoactive region for sensing a two-dimensional optical image.

The substrate 110 includes a first side 110a and a second side 110b. The first and second sides 110a, 110b of the substrate 110 are opposite to each other. In some embodiments, the substrate 110 may be made of a light-transmissive material allowing at least a part of a light entering from the second side 110b of the substrate 110 to pass though the substrate 110 and exit from the first side 110a of the substrate 110. However, the substrate 110 according to the present disclosure is not limited to a light-transmissive substrate. In other embodiments, the substrate 110 may be made of a material non-transparent to the light entering from the second side 110b of the substrate 110. In an example, the substrate 110 may be an InP substrate, which is transparent to light of a wavelength greater than 800nm. The substrate 110 may have a thickness in a range of, but not limited to, several hundred micrometers.

Here, the sensor layer 120 is deposited onto the substrate 110 (namely, formed on top of the substrate 110) and may include the optical sensor or array of optical sensors, such as diode implants. In other words, the sensor layer 120 is an additional layer on the first side 110a of the substrate 110, which serves as a carrier for preparing the sensor layer. The optical sensor may include a diode implant (such as an InGaAs photosensor array) and may have a thickness in the range of, but not limited to, a couple of micrometers.

The substrate 110 includes a central area that corresponds to or sits above the photoactive region of the sensor layer 120. The substrate 110 includes a substrate spacer 111 near the edge of the substrate 110 and outside of the central area. The substrate 110 includes a gap 160 in the central area and between the substrate 110 and the optical filter 140. In some embodiments, the substrate spacer 111 may be a rim surrounding the gap 160 and having an opening so as to not completely seal the gap 160. For example, the rim may be broken in at least one position to provide an opening connecting the gap from an inner side of the rim to an outer side of the rim. In other embodiments, the substrate spacer 111 may include a plurality of spacer sections separate from each other and surrounding the gap 160. For example, the substrate spacer may have two spacer sections on two respective edges of the second side of the substrate or may have three spacer sections, such as in a form of three pillars. Referring to Fig.1, the gap 160 extends from the optical filter 140 to the sensor layer 120. While illustrated as having a triangular cross-section in the figures, the substrate spacer 111 is not limited to a particular cross-sectional shape and may have different cross-sectional shapes, such as a trapezoidal shape or a rectangular shape.

The optical filter 140 is mounted before the sensor layer 120, more specifically, on the side of the substrate 110. As illustrated in Fig. 1, the optical filter 140 is attached to the substrate spacer 111 by an adhesive 150. The substrate spacer 111 thus serves as a mechanical spacer between the optical filter 140 and the sensor layer 120, which allows for maintaining a very well defined mean width of the gap 160 between the optical filter and the sensor layer. Thereby, the spatial homogeneity of this width across the surface of the sensor layer 120 is achieved. In particular, as shown in Fig. 1, the optical filter 140 is directly attached to the substrate spacer 111 and the spatial homogeneity is achieved without any additional holder structure for mounting the optical filter 140.

With reference to Fig. 1, the adhesive 150 is on a side of the substrate spacer 111 facing away from the gap 160. In other words, the substrate spacer 111 is between the adhesive 150 and the gap 160 and thereby prevents the adhesive 150 (or debris of the adhesive) from entering the gap 160. The substrate spacer 111 thus serves a first function of providing a well-defined geometrical shim and a second function of providing contact surfaces to attach the optical filter, e.g., by a liquid adhesive.

To provide a very well defined mean width of a gap between the optical filter and the sensor layer, the optical filter 140 has a flat surface facing the substrate spacer 111. The flat surface of the optical filter 140 is parallel the surface of the sensor layer 120 exposed to the gap 160. Especially, the first side 110a and the second side 110b of the substrate are parallel to each other. Thereby, it is possible to maintain the parallelism between the sensor layer 120 on the first side 110a and the optical filter 140 on the second side 110b by attaching the optical filter 140 to the substrate spacer 111.

As explained above, the pixel matrix sensor has a very compact and robust structure, in which the optical filter 140 is attached to the substrate spacer 111 that serves as a mechanical spacer and a holder structure for the optical filter 140. The pixel matrix sensor does not require any additional holder structure for mounting the optical filter, which leads to a tolerance chain and difficulty in controlling the width of the gap 160 between the optical filter 140 and the sensor layer 120. The pixel matrix sensor can therefore reduce the costs and the size. More importantly, a very well defined mean width of the gap 160 between the optical filter and the sensor layer can be achieved by the same compact and robust structure.

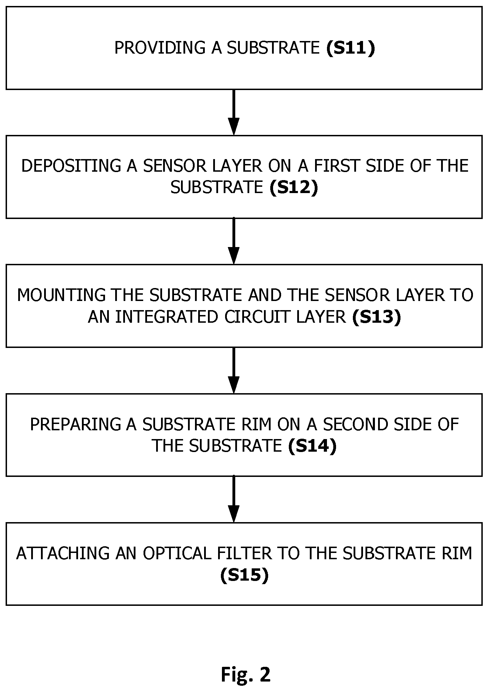

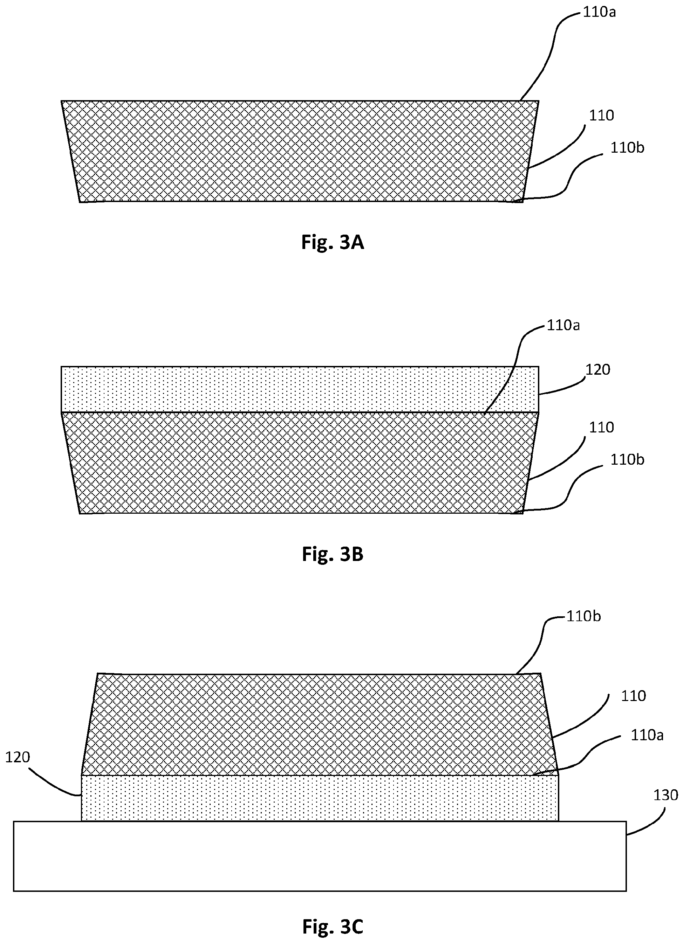

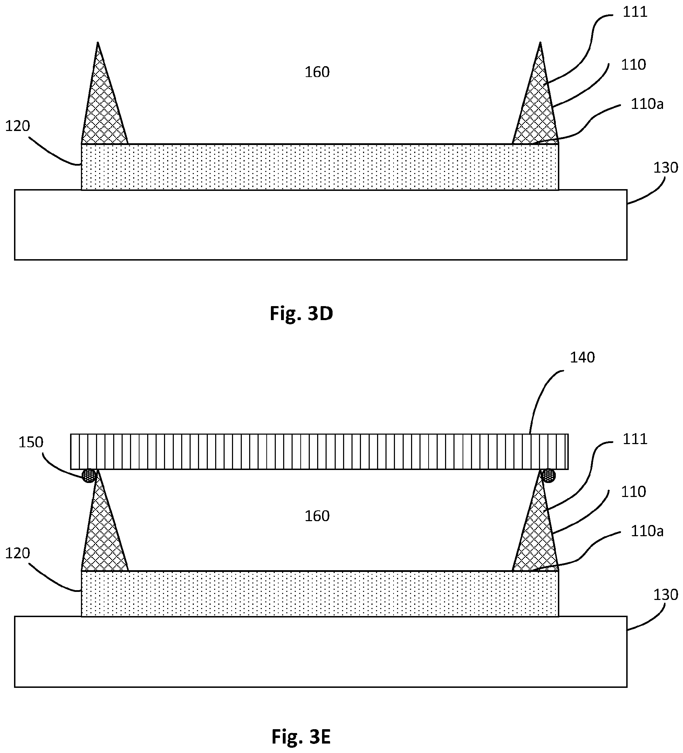

In the following, a method of preparing a pixel matrix sensor will be disclosed with reference to Fig. 2 and Figs. 3A to 3E.

The method begins at step S11 of providing a substrate 110. Referring to Fig. 3A, the substrate 110 includes a first side 110a and a second side 110b opposite to the first side 110a. In some embodiments, the substrate 110 may be non-transparent to the light entering from the second side 110b of the substrate 110. In other embodiments, the substrate 110 may include a light-transmissive material allowing at least a part of a light entering from the second side 110b of the substrate 110 to pass though the substrate 110 and exit from the first side 110a of the substrate 110.

In step S12, a sensor layer 120 is deposited onto the first side 110a of the substrate 110. Specifically, the sensor layer 120 may be grown and structured (to form diode implants as optical sensors) on the first side 110a of the substrate 110, as shown in Fig. 3B. The optical sensor or the array of optical sensor is in a photoactive region of the sensor layer 120 for sensing light or an optical image. Here, the sensor layer 120 is an additional layer formed onto the substrate 110 and may be grown by forming a diode implant. The dopant implants and optical sensors may be directly processed on the substrate 110 to form the sensor layer 120. The substrate 110 thus serves as a carrier for preparing the sensor layer 120. As an example, the optical sensor or the array of optical sensors may be an InGaAs photosensor array grown on an InP substrate or a HgCdTe photosensor array grown on a Ge substrate.

Then, in an optional step S13, the substrate 110 together with the sensor layer 120 may be mounted to an integrated circuit layer 130 with the sensor layer 120 facing the integrated circuit layer. That is, the sensor layer 120 and the substrate 110 in step S12 (and Fig. 3B) is flipped upside down and the sensor layer 120 is attached to the integrated circuit layer 130, as illustrated in Fig. 3C. The optical sensor or the array of optical sensors in the sensor layer 120 is thus electrically coupled to the circuit of the integrated circuit layer 130, which may be a readout integrated circuit layer configured to read signals sensed by the sensor layer 120. The pixel matrix sensor thus has a back-illuminated geometry.

In step S14, a substrate spacer 111 is prepared on a second side 110b of the substrate 110. Specifically, the substrate spacer 111 is prepared by removing the substrate 110 in a central area and leaving the substrate spacer 111 outside of the central area. In the embodiment illustrated in Fig. 3D, the substrate 110 is completely removed in the central area and the sensor layer 120 is exposed to the gap 160 after preparing the substrate spacer 111.

Finally, in step S15, an optical filter 140 is attached to the substrate spacer 111. This may be done by applying a liquid adhesive 150 to, for example, a perimeter of the optical filter 140. In particular, the liquid adhesive may be applied to a side of the substrate spacer 111 facing away from the gap 160 for attaching the optical filter 140 to the substrate spacer 111. Thereby, the substrate spacer 111 can prevent the liquid adhesive 150 from creeping into the gap 160.

According to the method as disclosed above, a substrate spacer 111 is prepared by removing the substrate 110 in the central area. That is, the substrate spacer 111 is integral with the substrate 110. This substrate spacer 111 then serves as a mechanical spacer and a holder for mounting the optical filter 140 before the sensor layer 120 in the pixel matrix sensor. It is thus possible to maintain a very well defined mean width of a gap 160 (namely, very good parallelism) between the optical filter 140 and the sensor layer 120 across the gap 160. The spatial homogeneity of this width can thus be easily achieved.

The method eliminates the need for an additional holder structure and provides an easy, cost-efficient, and robust way of mounting an optical filter 140 before the sensor layer 120 in a compact and robust structure.

Further, the height of the substrate spacer 111 and the width of the gap 160 between the optical filter 140 and the sensor layer 120 can be very well defined by controlling the thickness of the substrate 110 provided in the step S11 since the substrate spacer 111 is prepared by removing completely the substrate 110 in the central area and leaving the substrate spacer 111 outside of the central area. The width of the gap 160 between the optical filter 140 and the sensor layer 120 can therefore be easily maintained in the method as disclosed above for controlling the etaloning effects occurring in the gap 160. Further, the method can be used in preparing pixel matrix sensors of different materials and is not limited to particular materials of the pixel matrix sensor (such as the material of the optical filter or the material of the substrate).

The desired height of the substrate spacer or the desired width of the gap depends on the application. Generally, the width of the gap should be larger than the coherence length of the impinging light, namely, the light to be detected by the sensor layer. The coherence length of the light, on the other hand, depends on the width of the spectral slice that the optical filter transmits to a given pixel. The width of the gap may be typically in the order of a couple of µm to 100µm (compatible with typical substrate thicknesses).

While specific embodiments are described above with reference to the drawings, various modifications are covered by the present disclosure. In the following, some modifications of the present disclosure will be described by discussing the differences from the embodiments illustrated in Figs. 1 to 3.

In one modification, the optical filter 140 may be attached to the substrate spacer 111 by a mechanical structure of the optical filter 140 or an additional holder structure. The mechanical structure of the optical filter 140 or the additional holder structure can thus facilitate the step of attaching the optical filter 140 to the substrate spacer 111. As compared to the conventional method, this modification uses the substrate 110 of the pixel matrix sensor for mounting the optical filter 140 and does not require any surrounding structure for mounting the optical filter 140.

In one modification, the gap 160 may be filled with a material for improving optical properties. For example, instead of leaving the gap 160 filled with an ambient air, the gap 160 can be filled with a high refractive index material to artificially widen the optical width of the gap.

In one modification, the exposed surface of the sensor layer 120 may be structured to improve optical properties.

In one modification, an anti-reflection coating may be applied to the exposed surface of the sensor layer 120 before attaching the optical filter 140 to the substrate spacer 111.

The above embodiments and modifications are not intended to limit the scope of the present invention. Various implementations are covered by the scope of the present invention defined by the appended claims.

The above describes some aspects or elements of the pixel matrix sensor, with which the present disclosure is concerned. A person skilled in the art would understand from the common general knowledge that the pixel matrix sensor may include other aspects or elements (such as optical lenses, encapsulation, electrical coupling, etc.) for implementation of a pixel matrix sensor.

## Claims

1. A method of manufacturing a pixel matrix sensor, comprising following steps sequence:
providing (S11) a substrate (110) including a first side (110a) and a second side (110b) opposite to the first side (110a);
depositing (S12) a sensor layer (120) onto the first side (110a) of the substrate (110), the sensor layer (120) including an optical sensor in a photoactive region of the sensor layer (120); and
preparing (S14) a substrate spacer (111) on the second side (110b) of the substrate (110), the substrate (110) having a central area above the photoactive region of the sensor layer (120) and the substrate spacer (111) being outside of the central area of the substrate (110),
wherein the step of preparing the substrate spacer (111) includes:
removing completely the substrate (110) in the central area from the second side (110b) of the substrate (110) to create a gap (160) in the central area and expose a surface of the sensor layer (120) to the gap (160),
leaving the substrate spacer (111) on the second side (110b) of the substrate (110) forming thus the substrate spacer (111) integral with the substrate (110); and
attaching (S15) an optical filter (140) to the substrate spacer (111).

2. The method of claim 1,
wherein the substrate spacer (111) includes a plurality of spacer sections separate from each other.

3. The method of claim 1,
wherein the substrate spacer (111) includes a rim surrounding the gap (160),

4. The method of claim 3, wherein the rim has an opening connecting the gap from an inner side of the rim to an outer side of the rim.

5. The method of any of claims 1 to 4, wherein the step of attaching (S15) the optical filter (140) includes applying a liquid adhesive (150) between the optical filter (140) and the substrate spacer (111).

6. The method of claim 5, wherein the liquid adhesive (150) is applied to a side of the substrate spacer (111) facing away from the gap (160).

7. The method of any of claims 1 to 6,
wherein in the step of providing (S11) the substrate, the first side (110a) of the substrate (110) is parallel to the second side (110b) of the substrate (110).

8. The method of any of claims 1 to 7,
wherein the optical filter (140) has a flat surface facing the substrate spacer (111), the flat surface of the filter (140) being parallel to the surface of the sensor layer (160) exposed to the gap (160).

## Patentansprüche

1. Ein Verfahren zur Herstellung eines Pixelmatrixsensors, umfassend folgende Schrittabfolge:
Bereitstellen (S11) eines Substrats (110), das eine erste Seite (110a) und eine zweite Seite (110b), die der ersten Seite (110a) gegenüberliegt, aufweist;
Abscheiden (S12) einer Sensorschicht (120) auf der ersten Seite (110a) des Substrats (110), wobei die Sensorschicht (120) einen optischen Sensor in einem photoaktiven Bereich der Sensorschicht (120) umfasst; und
Herstellen (S14) eines Substratabstandshalters (111) auf der zweiten Seite (110b) des Substrats (110), wobei das Substrat (110) einen zentralen Bereich oberhalb des photoaktiven Bereichs der Sensorschicht (120) aufweist und sich der Substratabstandshalter (111) außerhalb des zentralen Bereichs des Substrats (110) befindet,
wobei der Schritt des Herstellens des Substratabstandshalters (111) umfasst:
vollständiges Entfernen des Substrats (110) in dem zentralen Bereich von der zweiten Seite (110b) des Substrats (110), um einen Zwischenraum (160) in dem zentralen Bereich zu erzeugen und eine Oberfläche der Sensorschicht (120) zu dem Zwischenraum (160) hin freizulegen,
Belassen des Substratabstandshalters (111) auf der zweiten Seite (110b) des Substrats (110), wodurch somit der Substratabstandshalter (111) einstückig mit dem Substrat (110) ausgebildet wird; und
Anbringen (S15) eines optischen Filters (140) an dem Substratabstandshalter (111).

2. Verfahren nach Anspruch 1,
wobei der Substratabstandshalter (111) eine Mehrzahl von Abstandshalterabschnitten umfasst, die voneinander getrennt sind.

3. Verfahren nach Anspruch 1,
wobei der Substratabstandshalter (111) einen den Zwischenraum (160) umgebenden Rand umfasst,

4. Verfahren nach Anspruch 3, wobei der Rand eine Öffnung aufweist, die den Zwischenraum von einer Innenseite des Randes mit einer Außenseite des Randes verbindet.

5. Verfahren nach einem der Ansprüche 1 bis 4, wobei der Schritt des Anbringens (S15) des optischen Filters (140) das Aufbringen eines flüssigen Klebstoffs (150) zwischen dem optischen Filter (140) und dem Substratabstandshalter (111) umfasst.

6. Verfahren nach Anspruch 5, wobei der flüssige Klebstoff (150) auf eine von dem Zwischenraum (160) abgewandte Seite des Substratabstandshalters (111) aufgebracht wird.

7. Verfahren nach einem der Ansprüche 1 bis 6,
wobei in dem Schritt des Bereitstellens (S11) des Substrats die erste Seite (110a) des Substrats (110) parallel zu der zweiten Seite (110b) des Substrats (110) ist.

8. Verfahren nach einem der Ansprüche 1 bis 7,
wobei der optische Filter (140) eine dem Substratabstandshalter (111) zugewandte flache Oberfläche aufweist, wobei die flache Oberfläche des Filters (140) parallel zu der zu dem Zwischenraum (160) hin freigelegten Oberfläche der Sensorschicht (160) ist.

## Revendications

1. Un procédé de fabrication d'un capteur à matrice de pixels, comprenant la séquence d'étapes suivante :
fournir (S11) un substrat (110) comprenant un premier côté (110a) et un second côté (110b) opposé au premier côté (110a) ;
déposer (S12) une couche de capteur (120) sur le premier côté (110a) du substrat (110), la couche de capteur (120) comprenant un capteur optique dans une région photoactive de la couche de capteur (120) ; et
préparer (S14) une entretoise de substrat (111) sur le second côté (110b) du substrat (110), le substrat (110) présentant une zone centrale au-dessus de la région photoactive de la couche de capteur (120) et l'entretoise de substrat (111) se trouvant à l'extérieur de la zone centrale du substrat (110),
dans lequel l'étape de préparation de l'entretoise de substrat (111) comprend :
retirer complètement le substrat (110) dans la zone centrale depuis le second côté (110b) du substrat (110) pour créer un espace (160) dans la zone centrale et exposer une surface de la couche de capteur (120) à l'espace (160),
laisser l'entretoise de substrat (111) sur le second côté (110b) du substrat (110), formant ainsi l'entretoise de substrat (111) d'un seul tenant avec le substrat (110) ; et
fixer (S15) un filtre optique (140) à l'entretoise de substrat (111).

2. Le procédé selon la revendication 1,
dans lequel l'entretoise de substrat (111) comprend une pluralité de sections d'entretoise séparées les unes des autres.

3. Le procédé selon la revendication 1,
dans lequel l'entretoise de substrat (111) comprend un rebord entourant l'espace (160),

4. Le procédé selon la revendication 3, dans lequel le rebord présente une ouverture reliant l'espace d'un côté intérieur du rebord à un côté extérieur du rebord.

5. Le procédé selon l'une quelconque des revendications 1 à 4, dans lequel l'étape de fixation (S15) du filtre optique (140) comprend l'application d'un adhésif liquide (150) entre le filtre optique (140) et l'entretoise de substrat (111).

6. Le procédé selon la revendication 5, dans lequel l'adhésif liquide (150) est appliqué sur un côté de l'entretoise de substrat (111) tourné à l'opposé de l'espace (160).

7. Le procédé selon l'une quelconque des revendications 1 à 6,
dans lequel, à l'étape de fourniture (S11) du substrat, le premier côté (110a) du substrat (110) est parallèle au second côté (110b) du substrat (110).

8. Le procédé selon l'une quelconque des revendications 1 à 7,
dans lequel le filtre optique (140) présente une surface plane faisant face à l'entretoise de substrat (111), la surface plane du filtre (140) étant parallèle à la surface de la couche de capteur (160) exposée à l'espace (160).
